# EUROPEAN PATENT APPLICATION

(11) **EP 4 376 046 A1**
(43) Date of publication of application: **29.05.2024**
(21) Application number: 22209458.3
(22) Date of filing: 24.11.2022
(51) Int. Cl.: H01J 37/04, H01J 37/28

(54) **ELECTRON-OPTICAL ELEMENT AND METHOD OF ASSESSING AN ELECTRON-OPTICAL ELEMENT**

(71) Applicant: ASML Netherlands B.V., 5500 AH Veldhoven (NL)
(72) Inventor: DE LANGEN, Johannes, Cornelis, Jacobus, 5500 AH Veldhoven (NL)
(74) Representative: ASML Netherlands B.V.

(57) **Abstract**

The present disclosure relates to electron-optical elements and methods for assessing electron-optical elements. In one arrangement, an electron-optical element comprises a substrate defining at least one aperture extending through the substrate between two planar surfaces. At least one of the planar surfaces comprises a plurality of marks formed on or in the planar surface. A distance between centers of at least one pair of adjacent marks is: equal to or less than half of a largest dimension of one of the at least one aperture; and/or equal to or less than half of a distance between centers of at least one pair of adjacent apertures, in a case where the at least one aperture comprises a plurality of apertures.

## Description

### FIELD

The present disclosure relates to electron-optical elements and methods for assessing electron-optical elements.

### BACKGROUND

When manufacturing semiconductor integrated circuit (IC) chips, undesired pattern defects, as a consequence of, for example, optical effects and incidental particles, inevitably occur on a substrate (i.e. wafer) or a mask during the fabrication processes, thereby reducing the yield. Monitoring the extent of the undesired pattern defects is therefore an important process in the manufacture of IC chips. More generally, the assessment for example inspection and/or measurement of a surface of a substrate, or other object/material, is an important process during and/or after its manufacture.

Assessment tools, which herein are referred to as assessment systems, are known that use a charged particle beam to assess objects, which may be referred to as samples, for example to detect pattern defects. These systems typically use electron microscopy techniques, such as a scanning electron microscope (SEM). In a SEM, a primary electron beam of electrons at a relatively high energy is targeted with a final deceleration step to land on a sample at a relatively low landing energy. The beam of electrons is focused as a probing spot on the sample. The interactions between the material structure at the probing spot and the landing electrons from the beam of electrons cause signal electrons to be emitted from the surface, such as secondary electrons, backscattered electrons or Auger electrons. The signal electrons may be emitted from the material structure of the sample. By scanning the primary electron beam as the probing spot over the sample surface, signal electrons can be emitted across the surface of the sample. By collecting these emitted signal electrons from the sample surface, a pattern inspection system may obtain an image representing characteristics of the material structure of the surface of the sample.

Assessment systems may use electron-optical elements to control beams of electrons. These electron-optical elements may define features such as apertures that are used to influence trajectories of the electrons, such as by providing lensing effects. Various aspects of the features may affect performance of the electron-optical element, such as shapes, sizes and/or positions of the features. However, it has proven difficult to measure these properties efficiently and with high accuracy.

### SUMMARY

It is an object of the present disclosure to provide methods and apparatus that support improved assessment of electron-optical elements.

According to an aspect of the invention, there is provided an electron-optical element for an electron-optical device, the electron-optical element comprising: a substrate having two planar surfaces and defining at least one aperture extending through the substrate between the two planar surfaces, wherein: at least one of the planar surfaces comprises a plurality of marks formed on or in the planar surface, a distance between centers of at least one pair of adjacent marks being: equal to or less than half of a largest dimension of one of the at least one aperture; and/or equal to or less than half of a distance between centers of at least one pair of adjacent apertures, in a case where the at least one aperture comprises a plurality of apertures.

According to an aspect of the invention, there is provided a method of assessing an electron-optical element for an electron-optical device, wherein the electron-optical element comprises: a substrate having two planar surfaces and defining at least one aperture extending through the substrate between the two planar surfaces, wherein: at least one of the planar surfaces comprises a plurality of marks formed on or in the planar surface, a distance between centers of at least one pair of adjacent marks being: equal to or less than half of a largest dimension of one of the at least one aperture; and/or equal to or less than half of a distance between centers of at least one pair of adjacent apertures, in a case where the at least one aperture comprises a plurality of apertures, and wherein the method comprises: capturing one or more images of respective portions of the substrate; detecting mark positions of at least a subset of the plurality of marks in the or each image; and determining geometrical information about the at least one aperture based on the one or more images and the detected mark positions.

### BRIEF DESCRIPTION OF FIGURES

The above and other aspects of the present disclosure will become more apparent from the description of exemplary embodiments, taken in conjunction with the accompanying drawings.
**FIG. 1** is a schematic diagram illustrating an exemplary charged particle beam inspection apparatus.
**FIG. 2** is a schematic diagram illustrating an exemplary multi-beam apparatus that is part of the exemplary charged particle beam inspection apparatus of **FIG. 1****.**
**FIG. 3** is a schematic diagram of an exemplary electron-optical device comprising a condenser lens array, an objective lens array and a detector array.
**FIG. 4** is a schematic cross-sectional view of a portion of an objective lens array and detector array of an exemplary arrangement.
**FIG. 5** is bottom view of the portion of the detector array of **FIG. 4****.**
**FIG. 6** is a bottom view of a modified version of the portion of the objective lens array of **FIG. 4****.**
**FIG. 7** is a schematic diagram of an exemplary electron-optical device comprising an objective lens array and a beam separator.
**FIG. 8** is a diagram of a further exemplary electron-optical device.
**FIG. 9** is a schematic diagram of an exemplary electron-optical assembly that may be part of the electron-optical devices of, for example, **FIG. 3****,** **7** and **8****.**
**FIG. 10** depicts a portion of an electron-optical element showing an array of apertures and an array of marks.
**FIG. 11** is a close-up view of a portion of the arrangement of **FIG. 10****.**
**FIG. 12** depicts a variation on the arrangement of **FIG. 10** in which marks are arranging symmetrically around the apertures.
**FIG. 13** depicts a further variation on the arrangement of **FIG. 10** in which the apertures are arranged in a rectangular grid and the marks are provided in different types of arrays.
**FIG. 14** is a schematic side sectional view of a portion of a substrate of an electron-optical element showing example apertures.
**FIG. 15** is a magnified schematic side sectional view of a portion of the substrate of **FIG. 14** in a case where the substrate has a base material (e.g., a base layer) and a covering (e.g., metallic) layer and marks are formed by recesses in the base material.
**FIG. 16** depicts a variation on the arrangements of **FIG. 15** in which marks are formed by providing variations in surface properties such as composition and/or surface finish.
**FIG. 17** depicts a variation on the arrangement of **FIG. 15** in which the marks are formed by localized portions of deposited material.

### DETAILED DESCRIPTION

Reference will now be made in detail to exemplary embodiments, examples of which are illustrated in the accompanying drawings. The following description refers to the accompanying drawings in which the same numbers in different drawings represent the same or similar elements unless otherwise represented. The implementations set forth in the following description of exemplary embodiments do not represent all implementations consistent with the invention. Instead, they are merely examples of apparatuses and methods consistent with aspects related to the invention as recited in the appended claims.

The enhanced computing power of electronic devices, which reduces the physical size of the devices, can be accomplished by significantly increasing the packing density of circuit components such as transistors, capacitors, diodes, etc. on an IC chip. This has been enabled by increased resolution enabling yet smaller structures to be made. For example, an IC chip of a smart phone, which is the size of a thumbnail and available in, or earlier than, 2019, may include over 2 billion transistors, the size of each transistor being less than 1/1000^{th} of a human hair. Thus, it is not surprising that semiconductor IC manufacturing is a complex and time-consuming process, with hundreds of individual steps. Errors in even one step have the potential to dramatically affect the functioning of the final product. Even a single defect can cause device failure in certain situations. The goal of the manufacturing process is to improve the overall yield of the process. For example, to obtain a 75% yield for a 50-step process (where a step can indicate the number of layers formed on a wafer), each individual step must have a yield greater than 99.4%. If each individual step had a yield of 95%, the overall process yield would be as low as 7%.

While high process yield is desirable in an IC chip manufacturing facility, maintaining a high substrate (i.e. wafer) throughput, defined as the number of substrates processed per hour, is also essential. High process yield and high substrate throughput can be impacted by the presence of a defect. This is especially true if operator intervention is required for reviewing the defects. Thus, high throughput detection and identification of micro and nano-scale defects by inspection systems (such as a Scanning Electron Microscope ('SEM')) is essential for maintaining high yield and low cost.

A SEM comprises a scanning device and a detector apparatus. The scanning device comprises an illumination apparatus that comprises an electron source, for generating primary electrons, and a projection apparatus for scanning a sample, such as a substrate, with one or more focused beams of primary electrons. Together at least the illumination apparatus, or illumination system, and the projection apparatus, or projection system, may be referred to together as the electron-optical device or column. The primary electrons interact with the sample and generate secondary electrons. The detection apparatus captures the secondary electrons from the sample as the sample is scanned so that the SEM can create an image of the scanned area of the sample. For high throughput inspection, some of the inspection apparatuses use multiple focused beams, i.e. a multi-beam, of primary electrons. The component beams of the multi-beam may be referred to as sub-beams or beamlets. A multi-beam can scan different parts of a sample simultaneously. A multi-beam inspection apparatus can therefore inspect a sample at a much higher speed than a single-beam inspection apparatus.

An implementation of a known multi-beam inspection apparatus is described below.

The figures are schematic. Relative dimensions of components in drawings are therefore exaggerated for clarity. Within the following description of drawings the same or like reference numbers refer to the same or like components or entities, and only the differences with respect to the individual embodiments are described. While the description and drawings are directed to an electron-optical apparatus, it is appreciated that the embodiments are not used to limit the present disclosure to specific charged particles. References to electrons throughout the present document may therefore be more generally be considered to be references to charged particles, with the charged particles not necessarily being electrons.

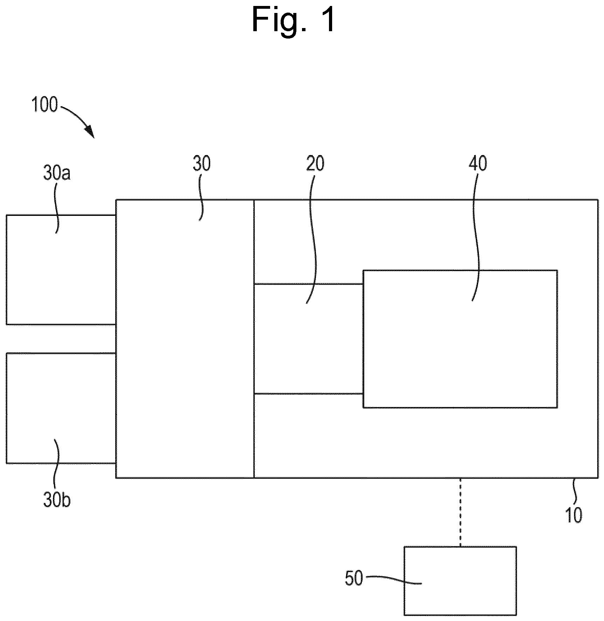

Reference is now made to **FIG. 1**, which is a schematic diagram illustrating an exemplary charged particle beam inspection apparatus 100, which may also be referred to as a charged particle beam assessment system or simply assessment system. The charged particle beam inspection apparatus 100 of **FIG. 1** includes a main chamber 10, a load lock chamber 20, an electron beam apparatus 40, an equipment front end module (EFEM) 30 and a controller 50. The controller may be distributed between different components of the assessment system, including for example in the electron beam apparatus 40. Electron beam apparatus 40 is located within main chamber 10.

EFEM 30 includes a first loading port 30a and a second loading port 30b. EFEM 30 may include additional loading port(s). First loading port 30a and second loading port 30b may, for example, receive substrate front opening unified pods (FOUPs) that contain substrates (e.g., semiconductor substrates or substrates made of other material(s)) or samples to be inspected (substrates, wafers and samples are collectively referred to as "samples" hereafter). One or more robot arms (not shown) in EFEM 30 transport the samples to load lock chamber 20.

Load lock chamber 20 is used to remove the gas around a sample. This creates a vacuum that is a local gas pressure lower than the pressure in the surrounding environment. The load lock chamber 20 may be connected to a load lock vacuum pump system (not shown), which removes gas particles in the load lock chamber 20. The operation of the load lock vacuum pump system enables the load lock chamber to reach a first pressure below the atmospheric pressure. After reaching the first pressure, one or more robot arms (not shown) transport the sample from load lock chamber 20 to main chamber 10. Main chamber 10 is connected to a main chamber vacuum pump system (not shown). The main chamber vacuum pump system removes gas particles in main chamber 10 so that the pressure in around the sample reaches a second pressure lower than the first pressure. After reaching the second pressure, the sample is transported to the electron beam apparatus by which it may be inspected. An electron beam apparatus 40 may comprise a multi-beam electron-optical apparatus.

Controller 50 is signally, for example electronically, connected to electron beam apparatus 40, for example as distributed components of the controller 50. Controller 50 may be a processor (such as a computer) configured to control the charged particle beam inspection apparatus 100. Controller 50 may also include a processing circuitry configured to execute various signal and image processing functions. While controller 50 is shown in **FIG. 1** as being outside of the structure that includes main chamber 10, load lock chamber 20, and EFEM 30, it is appreciated that controller 50 may be part of the structure. The controller 50 may be located in one of the component elements of the charged particle beam inspection apparatus or it can be distributed over at least two of the component elements. While the present disclosure provides examples of main chamber 10 housing an electron beam inspection apparatus, it should be noted that aspects of the disclosure in their broadest sense are not limited to a chamber housing an electron beam inspection apparatus. Rather, it is appreciated that the foregoing principles may also be applied to other systems and other arrangements of apparatus, that operate under the second pressure.

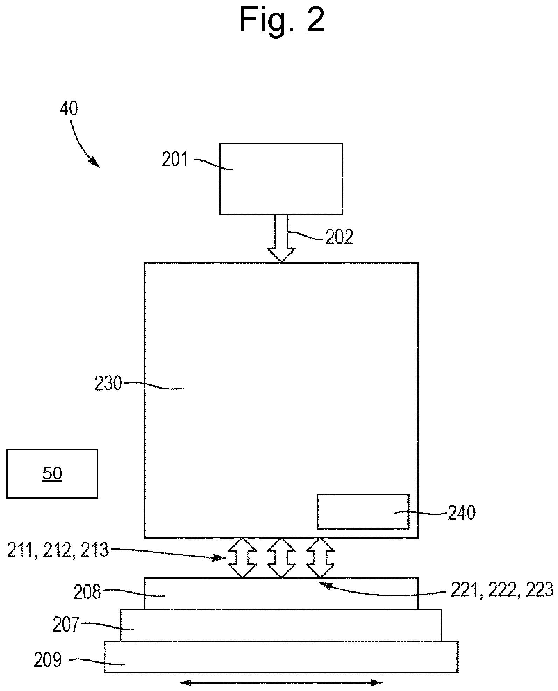

Reference is now made to **FIG. 2**, which is a schematic diagram illustrating an exemplary electron beam apparatus 40. The electron beam apparatus 40 may be provided as part of the exemplary charged particle beam inspection system 100 of **FIG. 1**. The electron beam apparatus 40 includes an electron source 201 and a charged particle column (or device) 230. The charged particle device 230 may be referred to or comprise a projection apparatus for directing a primary charged particle beam 202 towards a sample 208. The electron source 201 and associated and component charged particle optical elements may be referred to as an illumination apparatus for generating a primary charged particle beam 202. The apparatus comprises a sample support that supports a sample 208. The sample support in this example comprises a sample holder 207. The sample holder 207 holds the sample 208 (e.g., a substrate or a mask) for assessment. The sample holder 207 is supported by a motorized or actuated stage 209. The electron beam apparatus 40 further comprises a detector 240. The detector 240 detects signal charged particles (e.g., electrons) from the sample 208. The detector 240 generates detection signals on detection of the signal charged particles.

The electron source 201 may comprise a cathode (not shown) and an extractor or anode (not shown). During operation, electron source 201 is configured to emit electrons as primary electrons from the cathode. The primary electrons are extracted or accelerated by the extractor and/or the anode to form the primary electron beam 202.

The charged particle device 230 is configured to convert primary electron beam 202 into a plurality of charged particle beams 211, 212, 213 and to direct each beam onto the sample 208. Although three beams are illustrated for simplicity, there may be many tens, many hundreds, many thousands, many tens of thousands, or even hundreds of thousands (or more) of beams. The beams may be referred to as beamlets or sub-beams. The plurality of charged particle beams may be referred to collectively as a multi-beam or beam grid. A beam grid with so many beams (e.g. more than a thousand beams) may have a field of view of e.g. more than 0.5mm, for example in the range of 0.5 to 30mm or 1 to 30 mm, for example in the range of 0.5 to 15mm.

The controller 50 (for example control system comprising distributed controllers) may be connected to various parts of charged particle beam inspection apparatus 100 of **FIG. 1**, such as the electron source 201, the electron detection device 240, the charged particle device 230, and actuated stage 209. The controller 50 may perform various image and signal processing functions. The controller 50 may also generate various control signals to govern operations of the charged particle beam inspection apparatus 100, including operations of the electron beam apparatus 40.

The charged particle device 230 may be configured to focus, for example, beams 211, 212, and 213 onto a sample 208 for inspection and may form three probe spots 221, 222, and 223 on the surface of sample 208. The charged particle device 230 may be configured to deflect primary beams 211, 212, and 213 to scan probe spots 221, 222, and 223 across individual scanning areas in a section of the surface of sample 208. In response to incidence of primary beams 211, 212, and 213 on probe spots 221, 222, and 223 on sample 208, electrons are generated from the sample 208 which include secondary electrons and backscattered electrons which may be referred to as signal charged particles. The secondary electrons typically have electron energy as large as fifty electron volts (≤ 50 eV) and backscattered electrons typically have electron energy between fifty electron volts (50 eV) and the landing energy of primary beams 211, 212, and 213.

The detector 240 may send the detection signals generated in the detector 240, for example as an imaging or detection signal, to the controller 50 or a signal processing system (not shown which may be part of the controller 50), e.g. to construct images of the corresponding scanned areas of sample 208. The detector 240 may be incorporated at least partly into the charged particle device 230 or may be separate therefrom, for example where a secondary optical column directs secondary electrons to the detector 240.

The controller 50 may comprise an image processing system that includes an image acquirer (not shown) and a storage device (not shown). For example, the controller may comprise a processor, computer, server, mainframe host, terminals, personal computer, any kind of mobile computing devices, and the like, or a combination thereof. The image acquirer may comprise at least part of the processing function of the controller. Thus the image acquirer may comprise at least one or more processors. The image acquirer may be communicatively coupled to the detector 240 permitting signal communication, such as an electrical conductor, optical fiber cable, portable storage media, IR, Bluetooth, internet, wireless network, wireless radio, among others, or a combination thereof. The image acquirer may receive the detection signal from the detector 240, may process the data comprised in the signal and may construct an image therefrom. The image acquirer may thus acquire images of sample 208. The image acquirer may also perform various post-processing functions, such as generating contours, superimposing indicators on an acquired image, and the like. The image acquirer may be configured to perform adjustments of brightness and contrast, etc. of acquired images. The storage may be a storage medium such as a hard disk, flash drive, cloud storage, random access memory (RAM), other types of computer readable memory, and the like. The storage may be coupled with the image acquirer and may be used for saving scanned raw image data as original images, and post-processed images.

The image acquirer may acquire one or more images of a sample 208 based on an imaging signal received from the detector 240. An imaging signal may correspond to a scanning operation for conducting charged particle imaging. An acquired image may be a single image comprising a plurality of imaging areas. The single image may be stored in the storage. The single image may be an original image that may be divided into a plurality of regions. Each of the regions may comprise one imaging area containing a feature of sample 208. The acquired images may comprise multiple images of a single imaging area of sample 208 sampled multiple times over a time period. The multiple images may be stored in the storage. The controller 50 may be configured to perform image processing steps with the multiple images of the same location of sample 208.

The controller 50 may include measurement circuitry (e.g., analog-to-digital converters) to obtain a distribution of the detected secondary electrons. A part of the controller for such a function may be comprised in or proximate to the detector. The electron distribution data, collected during a detection time window, can be used in combination with corresponding scan path data of each of primary beams 211, 212, and 213 incident on the sample surface to reconstruct images of the sample structures under inspection. The reconstructed images can be used to reveal various features of the internal or external structures of sample 208. The reconstructed images can thereby be used to reveal any defects that may exist in and/or on, thus of the sample.

The controller 50 may control actuated stage 209 to move sample 208 during inspection of sample 208, for example to provide a scanning motion of the stage relative to the paths of the primary beams. The controller 50 may enable actuated stage 209 to move sample 208 in a direction such as part of the scanning motion of the stage, preferably continuously, for example at a constant speed, at least during sample inspection. The controller 50 may control movement of the actuated stage 209 so that it changes the speed of the movement of the sample 208 dependent on various parameters. For example, the controller may control the stage speed (including its direction) depending on the characteristics of the inspection steps and/or scans of the scanning process for example as disclosed in EPA 21171877.0 filed 3 May 2021 which is hereby incorporated by reference in so far as the combined stepping and scanning strategy at least of the stage. In controlling the actuated stage, actuation of the stage and thus the sample may enable the sample to be positioned, for example dynamically, relative to the paths of the primary beams.

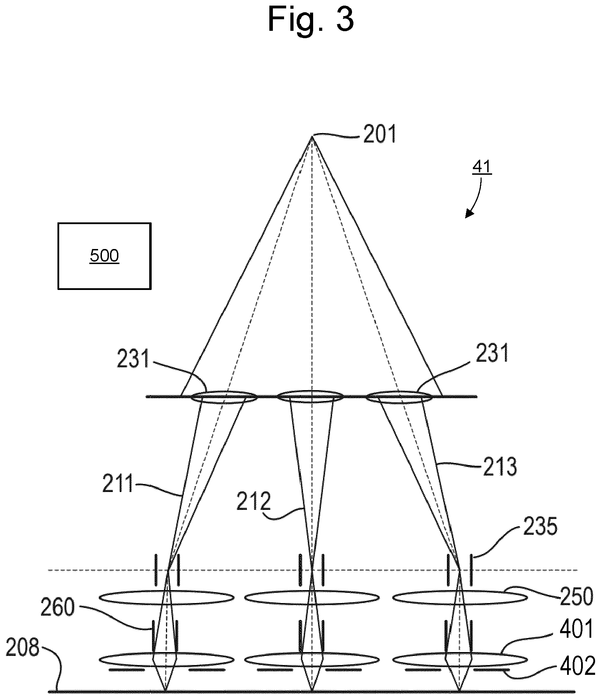

**FIG. 3** is a schematic diagram of an exemplary electron-optical device 41 (which may also be referred to as a charged particle device) for use in an assessment apparatus. For ease of illustration, lens arrays are depicted schematically herein by arrays of oval shapes. Each oval shape represents one of the lenses in the lens array. The oval shape is used by convention to represent a lens, by analogy to the biconvex form often adopted in optical lenses. In the context of electron-optical devices such as those discussed herein, it will be understood that lens arrays will typically operate electrostatically and so may not require any physical elements adopting a biconvex shape. As described below, lens arrays may instead comprise multiple plates with apertures. Each plate with apertures may be referred to as an electrode. The electrodes may be provided in series along a path of a beam grid of a plurality of charged particle beams (which may also be referred to as sub-beams). The electrodes are thus also in series along paths of charged particle beams of the beam grid.

Electron source 201 directs electrons toward an array of condenser lenses 231 forming part of electron-optical device 41. The electron source 201 is desirably a high brightness thermal field emitter with a good compromise between brightness and total emission current. There may be many tens, many hundreds or many thousands or even tens of thousands of condenser lenses 231. Condenser lenses of array 231 may comprise multi-electrode lenses and have a construction based on EP1602121A1, which document is hereby incorporated by reference in particular to the disclosure of a lens array to split an e-beam into a plurality of sub-beams, with the array providing a lens for each sub-beam. The condenser lens array may take the form of at least two, preferably three, plates, acting as electrodes, with apertures in each plate aligned with apertures in other plates to define paths for charged particle beams through the plates. At least two of the plates are maintained during operation at different potentials to achieve the desired lensing effect. Between the plates of the condenser lens array are electrically insulating plates, for example made of an insulating material such as ceramic or glass, with one or more apertures for the charged particle beams. Additionally or alternatively, one or more of the plates may feature apertures that each have their own electrode, for example with an array of electrodes around their perimeter or arranged in groups of apertures having a common electrode. In a variant, one or more of the plates may comprise multiple portions or strips with multiple apertures. In a further alternative arrangement, a macro collimator is provided instead of the condenser lens array. The macro collimator may act on the beam from the source 201 before the beam has been split into a multi-beam. The macro collimator may be implemented magnetically, electrostatically, or magnetically and electrostatically.

In some embodiments, the condenser lens array is formed of three plate arrays in which charged particles have the same energy as they enter and leave each lens, which arrangement may be referred to as an Einzel lens. Thus, dispersion only occurs within the Einzel lens itself (between entry and exit electrodes of the lens), thereby limiting off-axis chromatic aberrations. When the thickness of the condenser lenses is low, e.g. a few mm, such aberrations have a small or negligible effect.

Each condenser lens in the array directs electrons into a respective beam 211, 212, 213 which is focused at a respective intermediate focus 233. A collimator or an array of collimators may be positioned to operate on the respective intermediate focuses 233. The collimators may take the form of deflectors 235 provided at the intermediate focuses 233. Deflectors 235 are configured to bend a respective beam 211, 212, 213 by an amount effective to ensure that the principal ray (which may also be referred to as the beam axis) is incident on the sample 208 substantially normally (i.e. at substantially 90° to the nominal surface of the sample). Note that in an arrangement with a macro condenser lens, the condenser lens may collimate or contribute to the collimation of the source beam or, in an embodiment, a plurality of beams.

An objective lens array 401 is provided down-beam from the deflectors 235. The objective lens array 401 comprises an objective lens for each beam 211, 212, 213. The objective lens array 401 projects the beams 211, 212, 213 onto the sample 208. The objective lens array 401 may comprise two or more, preferably at least three, plate electrode arrays connected to respective potential sources.

Optionally, a control lens array 250 is provided between the deflectors 235 and the objective lens array 401. The control lens array 250 comprises a control lens for each beam 211, 212, 213. The control lens array 250 provides additional degrees of freedom for controlling properties of the beams 211, 212, 213. The control lens array 250 may comprise two or more, preferably at least three, plate electrode arrays connected to respective potential sources. A function of control lens array 250 is to optimize the beam opening angle with respect to the demagnification of the beam and/or to control the beam energy delivered to the objective lenses, each of which directs a respective beam 211, 212, 213 onto the sample 208. In an embodiment the control lens array may be considered to be part of the objective lens, for example in being additional plates associated with the objective lens array.

Optionally an array of scan deflectors 260 is provided between the control lens array 250 and the objective lens array 401. The array of scan deflectors 260 comprises a scan deflector for each beam 211, 212, 213. Each scan deflector is configured to deflect a respective beam 211, 212, 213 in one or two directions to scan the beam across the sample 208 in one or two directions. Alternatively, a macro scan deflector may be provided to scan the charged particle beams over the sample 208. The macro scan deflector may be provided up-beam of the control lens array 250. In an embodiment such a macro scan deflector may operate on the source beam and may be present with a macro condenser lens.

A detector module 402 of a detector is provided within the objective lenses or between the objective lenses and the sample 208 to detect signal electrons/particles from the sample 208. An exemplary construction of such a detector module 402 is described below. Note that the detector additionally or alternatively may have detector elements up-beam along the primary beam path of the objective lens array 401 or even the control lens array 250. The detector module may be an array of detector elements (e.g. a detector array). Each element may be associated with an individual beam, for example positioned to detect signal particles generated by the individual beam. The detector module may comprise at least one of scintillator elements, semiconducting elements or charge capture electrodes, for example to capture signal electrons as current.

The electron-optical device 41 of **FIG. 3** may be configured to control the landing energy of electrons on the sample 208 by varying potentials applied to the electrodes of the control lenses and the objective lenses. The control lenses and objective lenses work together and may be referred to as an objective lens assembly. The landing energy can be selected to increase emission and detection of secondary electrons dependent on the nature of the sample being assessed. The detector module may be comprised in the objective lens assembly.

The objective lenses can be configured to demagnify the electron beam by a factor greater than 10, desirably in the range of 50 to 100 or more. The objective lenses may comprise three electrodes: a middle electrode, a lower electrode and an upper electrode. The upper electrode may be omitted. An objective lens having only two electrodes can have lower aberration than an objective lens having more electrodes. A three-electrode objective lens can have greater potential differences between the electrodes and so enable a stronger lens. Additional electrodes (i.e. more than two electrodes) provide additional degrees of freedom for controlling the electron trajectories, e.g. to focus secondary electrons as well as the incident beams.

In some embodiments, the objective lens array assembly comprises a detector having a detector module 402 down-beam of at least one electrode of the objective lens array 401. The detector module 402 may comprise or even take the form of a detector array. In an embodiment, at least a portion of the detector is adjacent to and/or integrated with the objective lens array 401. For example, the detector module 402 may be implemented by integrating a CMOS chip detector into a bottom electrode of the objective lens array 401. Integration of a detector module 402 into the objective lens array may replace a secondary column. The CMOS chip is preferably orientated to face the sample (because of the small distance between sample and the bottom of the electron-optical system, which may for example be in the range of 10 to 400 micron, desirably in the range of 50 to 200 micron, optionally about 100 micron). It is noted that even in situations in which the detector is up-beam of the most down-beam electron-optical element of the charged particle device, there may be a close, e.g. of similar distance, separation between the most down-beam electron-optical element and the sample (e.g. about 100 micron). In an embodiment, electrodes to capture the signal charged particles are formed in the top metal layer of the CMOS device; thus the electrodes capture charge and may detect single charged particles as current, relative to time. The electrodes can be formed in other layers of the substrate, e.g. of the CMOS chip. Power and control signals of the CMOS may be connected to the CMOS by through-silicon vias. For robustness, preferably the bottom electrode consists of two elements: the CMOS chip and a passive Si plate with holes. The plate shields the CMOS from high E-fields.

In an embodiment, a single electrode surrounds at least some of the apertures. In an arrangement a single electrode is assigned for example around each aperture. In another embodiment, a plurality of electrode elements are provided around each aperture for example as a detector element. The signal charged particles captured by the electrode elements surrounding one aperture may be combined into a single detection signal or used to generate independent detection signals. The electrode elements may be divided radially (i.e., to form a plurality of concentric annuluses), angularly (i.e., to form a plurality of sector-like pieces), both radially and angularly (providing an arrangement like a dart board), or in a grid (for example as a chess board) or in any other convenient manner.

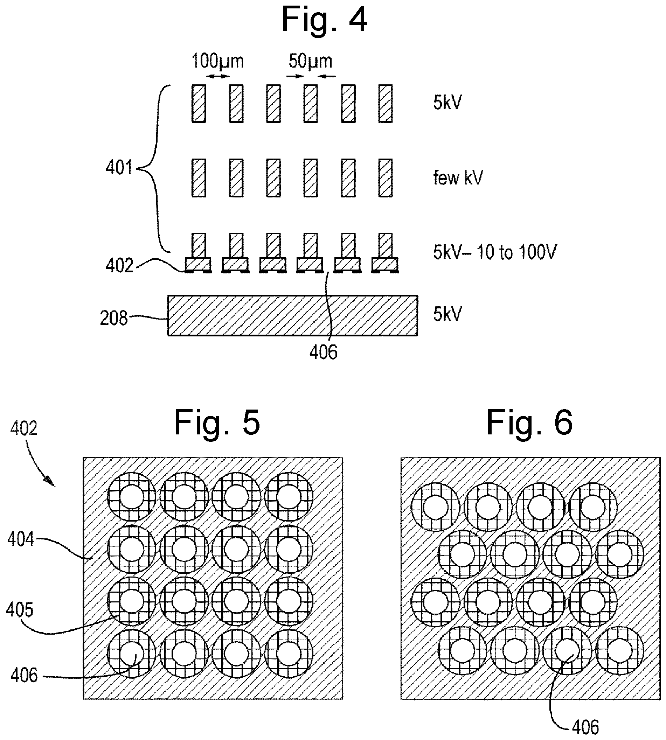

An exemplary embodiment of a detector integrated into an objective lens array 401 is shown in **FIG. 4**, which illustrates a portion of an objective lens array 401 in schematic cross section. In this embodiment, the detector comprises a detector module 402 comprising a plurality (e.g., an array) of detector elements 405, shown in **FIG. 5** (e.g., sensor elements such as capture electrodes), preferably as an array of detector elements (i.e. a plurality of detector elements in a pattern or arrangement preferably over a two dimensional surface). In this embodiment, the detector module 402 is provided on an output side of the objective lens array. The output side is the output side of the objective lens array 401. **FIG. 5** is a bottom view of detector module 402 which comprises a substrate 404 on which are provided a plurality of detector elements (or capture electrodes 405) each surrounding a beam aperture 406. The beam apertures 406 may be formed by etching through substrate 404. In the arrangement shown in **FIG. 5**, the beam apertures 406 are shown in a rectangular array. The beam apertures 406 can also be differently arranged, e.g. in a hexagonal close packed array as depicted in **FIG. 6**.

The integrated detector module 402 described above is particularly advantageous when used with an assessment apparatus (e.g. comprising an electron-optical device) having tunable landing energy because secondary electron capture can be optimized for a range of landing energies. A detector module having or in the form of an array can also be integrated into other electrode arrays, not only the lowest electrode array. Further details and alternative arrangements of a detector module integrated into an objective lens can be found in EP Application Number 20184160.8, which document is hereby incorporated by reference.

An electric power source may be provided to apply respective potentials to electrodes of, for example, the control lenses of the control lens array 250 and the objective lenses of the objective lens array 401 and the condenser lenses of the condenser lens array or any electron-optical element or component of the electron-optical device 41 for example the detector module (such as when integrated into the objective lens array or when the objective lens and detector module are separate components). A controller 50 may control the potentials applied to the electron-optical components such as the electrodes of the condenser lens array, objective lens array and/or control lens array.

The electron-optical device 41 may comprise other electron-optical components such as charged particle correctors, for example as corrector arrays for alignment of the source to the sample and between beams of the multi-beam and for adjusting the focus of different groups of the beam grid, or individual beams of the beam grid. Such correctors may be controlled to operate dynamically and/or statically, for example during step-up, servicing or during calibration of the electron-optical device 41.

In an embodiment, an array of electron-optical devices (or device array) is provided. The array may comprise a plurality of any of the electron-optical devices (e.g., electron-optical columns or charged particle devices) described herein. Each of the electron-optical devices in the array focuses respective pluralities of charged particle beams onto different regions of the same sample 208. Each electron-optical device in the array may derive a respective plurality of charged particle beams from a different respective source 201. Each respective source 201 may be one source in a plurality of sources 201. At least a subset of the plurality of sources 201 may be provided as a source array. The source array may comprise a plurality of emitters on a common substrate. The focusing of pluralities of charged particle beams from different electron-optical devices simultaneously onto different regions of the same sample allows an increased area of the sample 208 to be exposed to charged particle beams simultaneously. Therefore, an increased area of the sample may be processed (e.g. assessed) at one time. The electron-optical devices in the device array may be arranged adjacent to each other so as to project the respective pluralities of beams onto adjacent regions of the sample 208. Any number of electron-optical devices may be used in the array. Preferably, the number of electron-optical devices is in the range of 9 to 200. Each electron-optical device in the device array may be configured in any of the ways described herein when referring to a single electron-optical device, charged particle device or system or column. Alternatively or additionally, one or more of the electron-optical devices in the array may be configured to project a single beam.

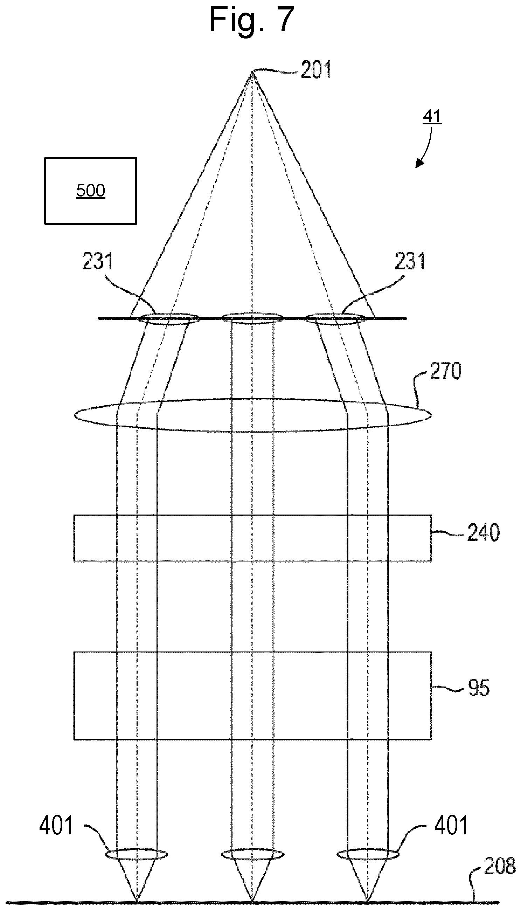

**FIG. 7** schematically depicts a further example of an electron-optical device 41. Features that are the same as those described above are given the same reference numerals. For conciseness, such features are not described in detail with reference to **FIG. 7**. For example, the source 201, the condenser lenses 231, the objective lens array 401 and the sample 208 (e.g., on a sample support 207) may be as described above. In this example, a macro collimator 270 is provided instead of a deflector array of the type described above with reference to **FIG. 3**. Such a macro collimator may be a macro lens that may be magnetic, electrostatic or both. In other embodiments, a deflector array may be used to at least contribute to the collimation of the beams, so the deflector array is for finer deflection towards collimation than the action of the macro collimator 270. Such an arrangement may also comprise an array of multiple deflectors (for example in which each aperture has multiple electrodes) for even finer collimation. In an arrangement the condenser lenses 231 may comprise a single plate defining a beam limiting aperture array in which are defined a plurality of apertures with one or more associated macro electrodes with a single aperture. Such a beam limiting aperture array and an associated macro electrode may also form a condenser lens array to focus the generated beams in an intermediate focus which desirably corresponds to the position of the collimator 270.

As described above, in some embodiments a detector may be provided between the objective lens array 401 and the sample 208. The detector may face the sample 208. Alternatively, as shown in **FIG. 7**, the detector 240 may be implemented such that the objective lens array 401 is between the detector 240 and the sample 208.

In an embodiment a deflector array 95 is provided between the detector 240 and the objective lens array 401. In an embodiment the deflector array 95 comprises a Wien filter array so that deflector array 95 may be referred to as a beam separator. The deflector array 95 is configured to provide a magnetic field and an electrostatic field. The electrostatic and magnetic fields operate together to separate the charged particles projected to the sample 208 relative to the signal particles e.g. electrons from the sample 208. The operation of the fields directs the signal particles towards the detector 240.

In an embodiment the detector 240 is configured to detect signal particles by reference to the energy of the charged particle, i.e. dependent on a band gap, such a semiconductor based type of detector. Such a detector 240 may be called an indirect current detector. The secondary electrons emitted from the sample 208 gain energy from the fields between the electrodes. The secondary electrons have sufficient energy once they reach the detector 240. In a different arrangement the detector 240 may be an electron to photon converter such as a scintillator array, for example of fluorescing strip between the beams that are positioned up beam along the primary beam path with respect to the Wien filter. Primary beams passing through the Wien filter array (of magnetic and electrostatic strips orthogonal to the primary beam path) have paths upbeam and downbeam of the Wien filter array that are substantially parallel, whereas signal electrons from the sample are directed by the Wien filter array towards the scintillator array. The electron to photon converter may be photonically coupled to a photon to electron converter to convert any photons generated in and emitted by the electron to photon converter. The photon to electron converter may be electrically connected to electronic circuitry to process a detection signal. In different embodiments the photon to electron converter may be within or external to the charged particle device. In an embodiment photon coupling may be by via a photon transport unit (e.g., an array of optical fibers) to a remote optical detector which generates a detection signal on detection of a photon.

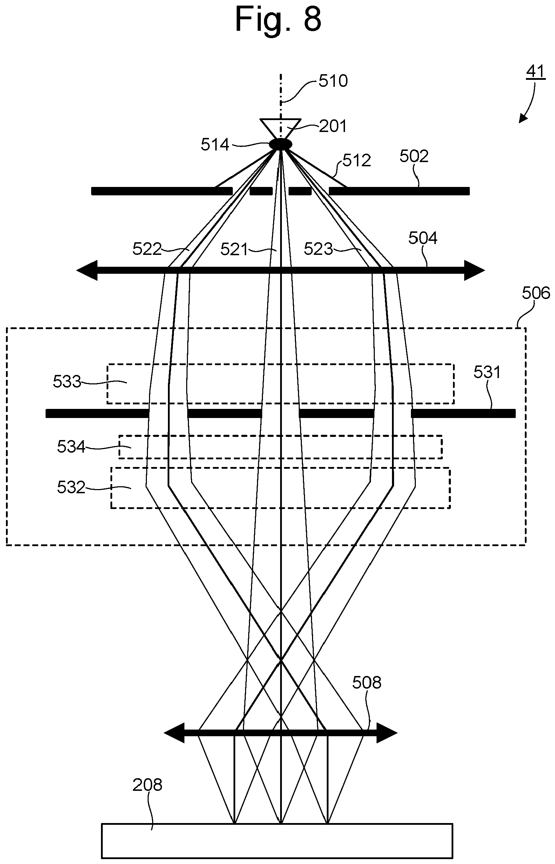

**FIG. 8** is a schematic diagram of a further exemplary electron-optical device 41 for use in an assessment apparatus. The electron-optical device 41 may be used in combination with any of the embodiments described herein, for example instead of any of the electron-optical devices 41 described above, such as with reference to **FIG. 3** and/or **FIG. 7**. In this example, the electron-optical device 41 comprises an electron source 201, a beam-forming aperture array 502, a condenser lens 504, a source conversion unit 506, an objective lens 508, and a sample 208. The source 201 and the sample 208 may take any of the forms described above with reference for example to **FIG. 2****,** **3** and **7** for example. The source 201, beam-forming aperture array 502, condenser lens 504, source conversion unit 506, and objective lens 508 may be aligned with a primary electron-optical axis 510 of the charged particle device 41. The source 201 generates a primary electron beam 512 with a source cross-over 514. The beam-forming aperture array 502 forms beams 521, 522, 523 from the primary beam 512. A line of three beams is depicted but the beam-forming aperture array 502 may be configured to form a line of two beams or a line of more than three beams, such as a line of four beams or a line of five beams. The beam-forming aperture array 502 may also be configured to form multiple lines of beams, thereby forming an array of beams. For example, the beam-forming aperture array 502 may be configured to form an n × m array of beams where *n* and *m* are integers that may be the same or different, such as a 3 × 3 array of beams, a 4 × 4 array of beams, or a 5 × 5 array of beams.

The condenser lens 504 may be configured to re-direct paths of the beams 521, 522, 523 to be substantially parallel to each other and/or to be incident substantially perpendicularly onto the source conversion unit 506. The condenser lens 504 may be a macro magnetic lens arrangement such as a multiple, e.g. two, lenses set at a non-rotational setting (by which the rotational effect of the different lenses of the lens arrangement cancel or their net rotational effect on the paths of the beams is substantially zero).

The source conversion unit 506 may include a beam-limiting aperture array 531 defining apertures configured to laterally limit each of the beams 521, 522, 523. The beam-limiting aperture array 531 may shape one more of the beams 521, 522, 523 for example to separate the beams into two or more beams down beam of the beam-limiting aperture array 531 for example towards a sample.

The source conversion unit 506 may comprise an array of electron-optical components for operating on each beam or a group of beams of the plurality of beams. The source conversion unit 506 may include an image-forming element array 532 comprising an array of micro-deflectors configured to deflect the beams 521, 522, 523 towards the axis 510. The deflected beams 521, 522, 523 may form virtual images of the source crossover 514 on the sample 208.

The source conversion unit 506 may include an aberration compensator array 534 configured to compensate aberrations in the beams 521, 522, 523. The aberration compensator array 534 may be configured to compensate for field curvature and/or astigmatism for example.

The source conversion unit 506 may include a pre-bending micro-deflector array 533 configured to bend paths of the beams 521, 522, 523 upbeam of the beam-limiting aperture array 531, for example to cause paths of the beams 521, 522, 523 to be incident substantially perpendicularly onto the beam-limiting aperture array 531.

The image-forming element array 532, the aberration compensator array 534, and/or the pre-bending micro-deflector array 533 may comprise multiple layers of sub-beam manipulating devices, some of which may be in the form of arrays, for example: micro-deflectors, micro-lenses, and/or micro-stigmators.

In the example shown, the objective lens 508 comprises a magnetic lens that acts macroscopically on the beams to focus the beams onto the sample 208. In other embodiments, the objective lens 508 may comprise an objective lens array implemented electrostatically, or a combination of magnetic and electrostatic lenses may be used; for example a macro magnetic objective lens with electrostatic elements.

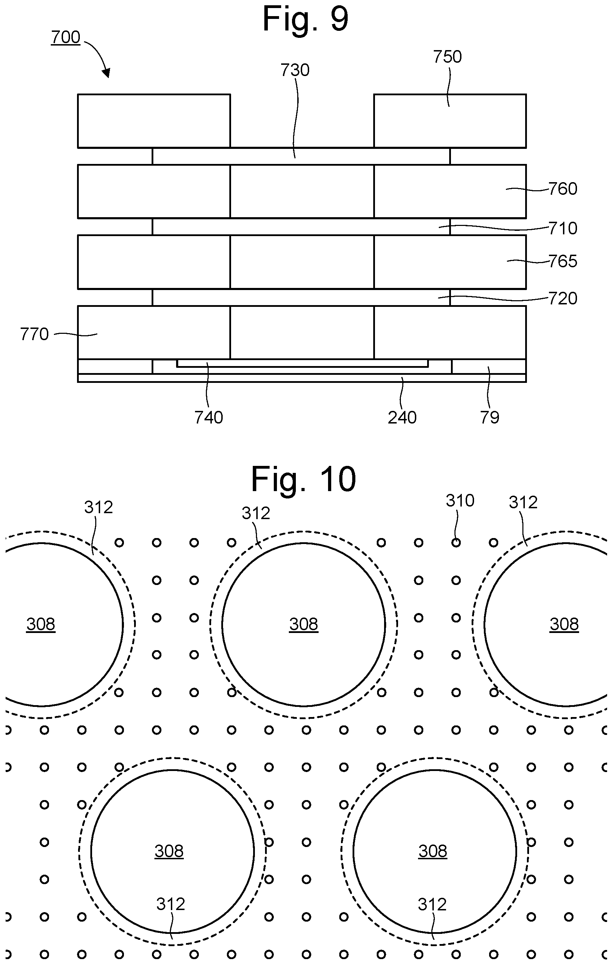

**FIG. 9** depicts an electron-optical assembly 700. The electron-optical assembly may form part of any of the electron-optical devices 41 disclosed herein. The electron-optical assembly may be an electron-optical lens assembly. For example, the electron-optical lens assembly may comprise an objective lens array or assembly, or a condenser lens array or assembly, or may be an objective lens array or assembly, or a condenser lens array or assembly. However, it is not essential for the electron-optical assembly 700 to be or comprise an electron-optical lens assembly. Additionally or alternatively, the electron-optical assembly 700 may comprise, for example as a respective array, a collimator, a corrector such as an individual beam corrector, a detector array, a deflector and/or one or more elements of a Wien filter array.

The electron-optical assembly 700 may be a macro component that manipulates a single beam (which may be separated into multiple beams downbeam) that passes through a large aperture in the electron-optical assembly 700. Alternatively, the electron-optical assembly 700 may comprise arrays of apertures and may be configured to manipulate a plurality of electron beams that pass through the apertures.

As exemplified in **FIG. 9**, in an embodiment the electron-optical assembly 700 comprises a plurality of electron-optical elements. The electron-optical elements may be planar. The electron-optical elements may each comprise a plate 710, 720, 730, 740, 240. The plates may each be set to a potential so may be referred to as electrodes or electrode plates. The depicted arrangement comprises five electron-optical elements of which the fifth element is a detector 240. In the depiction, four electrode plates 710, 720, 730, 740 are shown; so the depicted arrangement may have at least four electron-optical elements. In an arrangement, such an electron-optical assembly may have one or more electron-optical elements, desirably two or more electron-optical elements. Each electron optical element (or plate) 240, 710, 720, 730, 740 has one or more apertures around a beam path of the one or more electron beams. The arrangement shown in **FIG. 9** shows four electrode plates 710, 720, 730, 740 and a detector plate of the detector 240. The plates may be electrically isolated from each other. In the arrangement shown, an isolating spacer 765 electrically isolates upbeam plate 710 from downbeam plate 720. The upbeam plate and the downbeam plate are located between a most upbeam electron-optical element (comprising a most upbeam plate 730) and a most downbeam electron-optical element (comprising a most downbeam electrode plate 740) of the at least four electron-optical elements.

As shown in **FIG. 9**, in an embodiment one or more plates may be located downbeam of the most downbeam electron-optical element of the at least four electron-optical elements. For example, a detector plate forming the detector 240 may be positioned downbeam of the most downbeam electrode plate 740 of the lens elements. In an embodiment, the detector 240 is set to a potential different from an adjacent electron-optical element 740 along the path of the charged particle beam. In such an arrangement the spacer 79 between the most down beam electrode plate 740 and the detector is electrically isolating. In a different arrangement, the detector 240 is set to the same potential as the adjacent electron-optical element 740; the spacer 79 (or connecting element) between the detector 240 and the adjacent electron-optical element is electrically conductive.

In an embodiment the potential applied to the most downbeam electrode plate 740 of the lens elements is controlled to have a fixed potential relative to the sample 208. In a mode of operation of an electron-optical device 41 comprising the electron-optical assembly 700, the potential (or voltage) applied to the most downbeam electrode plate 740 may be maintained to be substantially constant. In an embodiment the voltage (or potential) applied to the most upbeam plate 730 may be controlled to be fixed relative to the source 201. When the voltages (or potentials) are controlled to control the landing energy, the electric fields in the electron-optical assembly 700 may change. When the electric fields change, the focus of the electron beams on the sample may change undesirably. In an embodiment the controller 50 is configured to control the voltages (potentials) applied to the upbeam plate 710 and/or the downbeam plate 720 to compensate the change in focus caused by the changing electric fields. The detector 240 may be considered a further electron-optical element because it may be set to a potential different from an adjacent electron-optical element 740 along the path of the charged particle beam; alternatively the detector is set to the same potential as the adjoining electron-optical element.

As exemplified in **FIG. 9**, other plates of the electron-optical assembly 700 may be separated by different types of isolating spacers 750, 760, 765, 770, 79. Some of these spacers 750, 760, 770 may be stepped in structure. Others may have a uniform cross section. In an embodiment, as exemplified in **FIG. 9**, the detector 240 is attached to one of the spacers 770 (or adjoining spacer) by the connecting element 79. The connecting element 79 may be an electrical isolator, or spacer with an aperture (i.e. a spacer being variant in design relative to the other isolating spacers) The aperture is sized to accept the most down beam electrode plate 740 and an intermediate thermally isolating gap which may also be electrically isolating. Thermal separation of the detector 240 and the adjoining plate 720 may be desirable because the thermal requirements of the detector 240 and adjoining electrode plate 720 are different. The connecting element may be connected to a conditioning conduit in addition to or as an alternative to the adjoining spacer 770. The connecting element 79 may directly thermally connect the detector 240 to the cooling conditioning conduit. The conditioning conduit may be positioned outside the adjoining spacer relative to the adjoining electrode plate 720.

Use of the connecting element 79 between the adjoining spacer 770 and the detector 240 may enable closer positioning of the detector 240 and the adjoining electrode plates 740 than would otherwise be the case if a regular isolating spacer such as of a design of the other spacers depicted 750, 760, 765 and 770 were to be positioned between the bottommost electrode plate 740 and the detector array 240, setting a focal length defined by the dimensions of the spacer, the detector array 240 and the bottom most electrode plate 740 along the beam path. The connecting element 79 may desirably enable an electron-optical design having a short focal length along the beam path; for example the dimensions along the beam path of the connecting element and the detector 240 (i.e. removing the dimension along the beam path of the bottom most electrode plate 740 and reducing the effective dimension of the path length of the spacer). In a variation the connecting element may be comprised in (e.g. part of) the adjoining spacer 770, for example having the surface dimensions as the adjoining spacer 770 and the connecting element 79. As depicted the isolator has a uniform diameter along the path of the charged particle beam. The detector may have a separate electrical connection from the adjacent electron-optical element 740 along the path of the charged particle beam (e.g. multibeam). The separate connection may be for signally connecting the detector for example to a controller, such as controller 50, for communicating control signals to the detector and/or detection signals from the detector.

In an embodiment the electron-optical assembly 700 comprises one or more electron-optical elements which comprise a microelectromechanical components (e.g., elements manufactured using MEMS techniques). The electron-optical assembly 700 may be a module, such as an electron-optical module which may referred to as a MEMS module (for example in view of the nature of one or more of the electron-optical components comprised in the module). In an embodiment the electron-optical assembly 700 can be replaced within the electron-optical device 41.

As described above, electron-optical elements may be provided that act as electrodes, for example as part of an objective lens array. Arrays of apertures in the electrodes allow charged particle beams to pass through the electrodes. Electric fields adjacent to the apertures may apply a lensing effect to the charged particles. In some arrangements, the apertures may be adapted to compensate for aberrations, for example for off-axis aberrations in a multi-beam such as distortion, focus curvature, astigmatism and coma. For example, the apertures of one or more of the electrodes may be shaped, sized and/or positioned to compensation for the off-axis aberrations. The apertures may, for example, have a range of different areas (or a range of diameters) to compensate for field curvature, a range of different ellipticities to compensate for astigmatism, and/or a range of different displacements from nominal grid positions to compensate for distortion caused by telecentricity error. See for example EPA 21166214.3 filed on 31 March 2021 which is hereby incorporated by reference so far as off-axis aberration correction.

Performance of electron-optical elements may be highly sensitive to variations in properties of the apertures such as their shapes, sizes and/or positions, particularly where these features are deliberately configured to correct for aberrations. As mentioned in the introductory part of the description, measuring these properties efficiently and with high accuracy is challenging. The properties may be measured by capturing images of the apertures. Extracting useful information from such images requires precise calibration of the length scale in the images. The length scale can vary as a function of direction and/or position within each image and/or from image to image. Inaccuracies in length scale can accumulate across an image and lead to large measurement errors for features that are relatively large and/or spaced apart by large distances in the image.

A scanning electron microscope (SEM) may be used to capture the images. A scale accuracy in an SEM may be dependent on various features of the SEM apparatus, including electronics and internal calibration factors. In some typical implementations, errors in the accuracy of the scale of the SEM can be multiple nm per pixel. Similar limitations are present in other imaging techniques that may be used to capture images of the apertures. To extract the most accurate information about shapes, sizes and/or positions of apertures in images, it is desirable to calibrate the images. The calibration may include calibration of length scales within the images.

In some arrangements, the calibration of an image is performed using reference features in the image that define a known scale. For example, a reference feature may comprise two elements having a known spatial relationship with respect to each other, such as a known separation between them. The known spatial relationship can be used to calibrate a scale of the image at least in the region between the two elements. For example, neighboring apertures may be used as a reference feature. The separation between the centers of neighboring apertures, which may be referred to as the beam pitch, can be known with high accuracy. The beam pitch may be defined by a highly accurate reticle (e.g., 10-20nm), which after demagnification onto a wafer during manufacture may be of the order of nanometer accuracy over a length scale of 100s of microns. Where apertures are arranged on an X-Y rectangular grid, for example, the beam pitch along an X-direction may be used to calibrate the X-axis scale in an image of the apertures and the beam pitch along a Y-direction may be used to calibrate the Y-axis scale.

Using beam pitch as a reference feature requires that the field of view of the image needs to be larger than the beam pitch, typically of the order of at least 1.5 times the beam pitch, so that multiple apertures can be seen and used to obtain the beam pitch. Such a large field of view may limit resolution and/or throughput. Embodiments of the present disclosure aim to address this issue.

In an embodiment, there is provided an electron-optical element for an electron-optical device. The electron-optical device may take any of the forms described above for example with reference to **FIG. 3****,** **7** and **8**. In an arrangement, the electron-optical device may comprise a detector (e.g., comprising a detector module 402) configured to detect signal charged particles from a sample 208. The detector may take any of the forms described above, including with reference to **FIG. 4** to 6. The electron-optical element may take any of the forms described above with reference to **FIG. 9**, including for example a plate 710, 720, 730, 740 defining apertures.

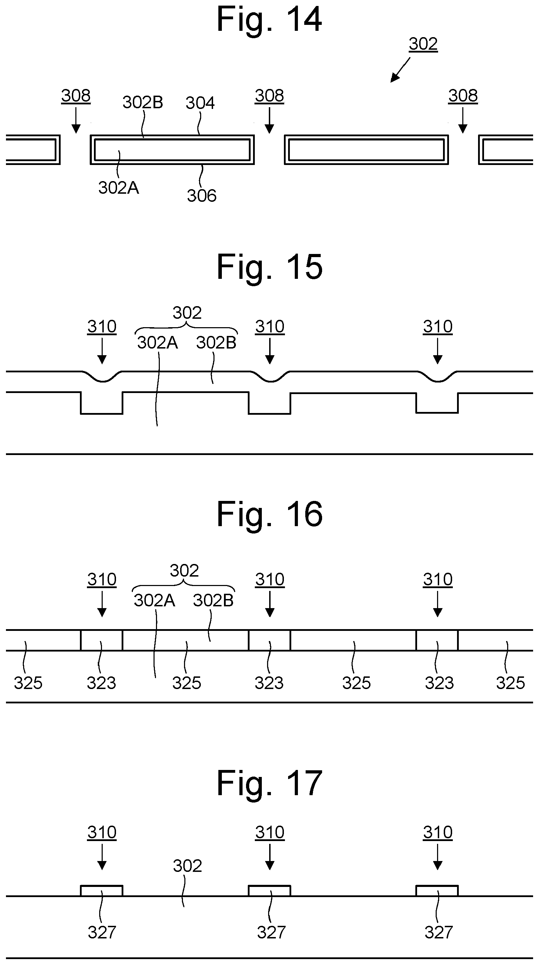

In an arrangement, as exemplified in **FIG. 14-17**, the electron-optical element comprises a substrate 302. The substrate 302 has two planar surfaces 304, 306, as depicted in **FIG. 14**. The substrate 302 defines at least one aperture 308 extending through the substrate 302 between the two planar surfaces 304, 306. The electron-optical device may comprise a stack of the electron-optical elements to allow manipulation of at least one charged particle beam propagating along a beam path through the stack by application of different potentials to the electron-optical elements. Apertures in the electron-optical elements may be aligned along the beam paths to allow the charged particle beams to pass though the electron-optical elements by passing through the aligned apertures. The substrate 302 may be planar, for example as a plate. The substrate 302 may be an electrode such as a planar electrode or electrode plate (such as a planar component comprising a series of electrodes such as in which apertures are defined) which may be part of an electron-optical lens arranged along the beam path. The substrate 302 may be configured to act as, or be part of, a beam-limiting aperture array, a corrector array, and/or a detector array.

At least one of the planar surfaces 304, 306 comprises a plurality of marks 310 formed on or in the planar surface 304, 306. A distance between centers of at least one pair of adjacent marks is arranged to be equal to or less than half of a largest dimension of one of the at least one aperture. In some arrangements, the distance between mark centers is significantly smaller, optionally less than 25% of the largest aperture dimension, optionally less than 10% of the largest aperture dimension, optionally less than 1% of the largest aperture dimension, optionally less than 0.1% of the largest aperture dimension. Alternatively or additionally, where the at least one aperture comprises a plurality of apertures, a distance between centers of at least one pair of adjacent marks is equal to or less than half of a distance between centers of at least one pair of adjacent apertures. In some arrangements, the distance between mark centers is significantly smaller, optionally less than 25% of the distance between aperture centers, optionally less than 10% of the distance between aperture centers, optionally less than 1% of the distance between aperture centers, optionally less than 0.1% of the distance between aperture centers.

Thus, marks 310 are provided that are relatively closely spaced in comparison with a size of the aperture 308 and/or a spacing between the apertures 308 (which may define a beam pitch). The spacing between the marks 310 can be defined with high precision and is known before any image is formed of the electron-optical element to assess apertures 308 in the electron-optical element (e.g., to measure shapes, sizes and/or positions of apertures as described above). Calibration information can be obtained using an image with a much smaller field of view than is possible using alternative techniques that rely on larger reference features (such as a beam pitch). For example, calibration information can be obtained from an image captured using a field of view that is small enough to capture a full outline of only a single aperture. Calibration can thus be performed with higher accuracy (higher resolution) and/or higher throughput.

The plurality of marks 310 are arranged in a pattern. The pattern may take various forms subject to the constraints mentioned above concerning the distances between centers of adjacent marks. Examples of patterns are discussed below with reference to **FIG. 10-13**.

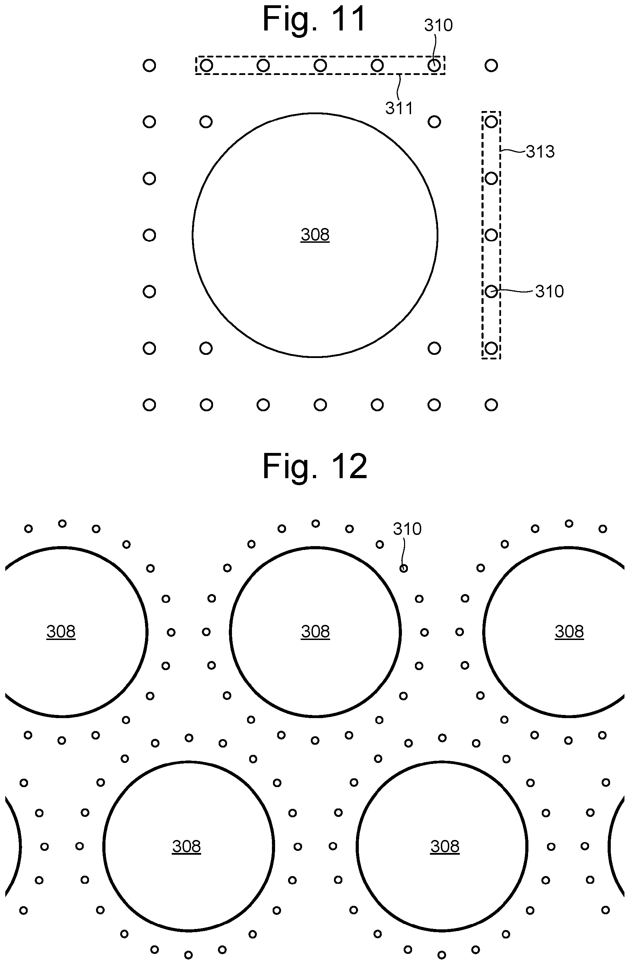

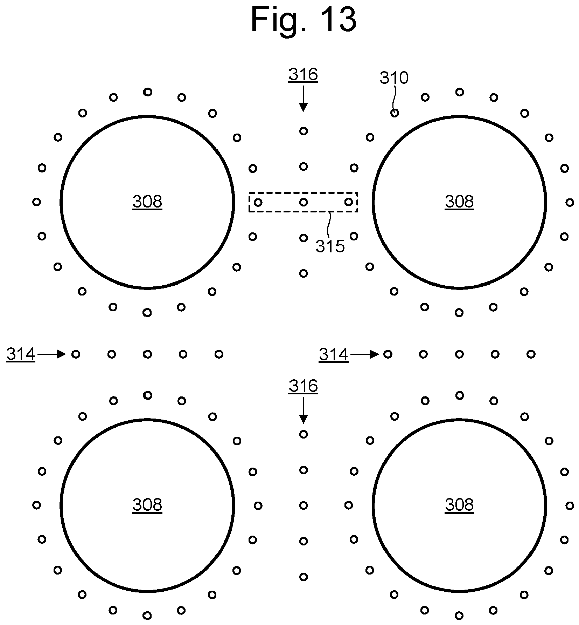

In an arrangement, the pattern comprises an array of marks 310 having a common pitch. The array of marks 310 may comprise a plurality of marks 310 arranged along a line with the common pitch, desirably three or more marks, such as four marks, five marks, six marks, ten marks, 50 marks, 100 marks, 500 marks, etc. Providing three or more marks 310 along a line with a common pitch makes it possible to make multiple independent measurements of the common pitch. Making multiple measurements allows accuracy to be improved due to averaging. The line may be a straight line. Examples of multiple marks 310 arranged with a common pitch along a straight line are shown in **FIG. 10****,** **11** and **13**. For example, broken line box 311 in **FIG. 11** shows five marks 310 arranged with a common pitch along a straight line aligned with the X-axis. Broken line box 313 in **FIG. 11** shows five marks 310 arranged with a common pitch along a straight line aligned with the Y-axis. In other arrangements, as will be described in further detail below with reference to **FIG. 12** and **13**, the line may be curved, for example substantially circular. The line may surround one of the apertures 308. The line may be coaxial with the aperture 308.

Different pluralities of marks 310 may be arranged along different respective lines (e.g., straight lines) that are angled relative to each other, such as angled perpendicularly. Marks may be provided for example along lines that are aligned with an X-axis and along lines that are aligned with a Y-axis, perpendicular to the X-axis. Alternatively or additionally, marks may be provided along lines that are angled relative to each other at other angles, such as parallel to axes defining a hexagonal grid of marks (e.g., at 60 degrees). In such an arrangement the marks may be aligned along lines of each of the three axes of the hexagonal grid.

In an arrangement, the array is a two-dimensional array. The marks 310 may have the same common pitch parallel to different axes of the two-dimensional array. Alternatively, the marks 310 may have different pitches parallel to different axes of the two-dimensional array. For example, the marks 310 may have a first common pitch parallel to an X-axis and a second common pitch parallel to a Y-axis perpendicular (for example) to the X-axis, where the first and second common pitches are different.

The two-dimensional array may comprise a grid. Centers of the marks 310 may be positioned at grid points defined by respective intersections between grid lines defining the grid. The grid may have any geometry, including for example rectangular (including square), hexagonal, and rhomboidal. Marks 310 may be absent from some of the grid points, such as where an aperture 308 or other feature is present that makes it inappropriate or impossible to provide a mark 310 at that location. This situation is exemplified in **FIG. 10** for example where the marks 310 are positioned at grid points of a square grid except for where apertures 308 are present and in a zone 312 surrounding each aperture 308 (indicated in the figure as a region between a broken line circle and an outer perimeter of each aperture 308). It is desirable to ensure that marks 310 are sufficiently far from the apertures 308 that the marks 310 do not interfere with edges of the apertures 308. For example, the zone 312 may be arranged to be wide enough to avoid any possibility of interference due to etch effects such as etch tilt and to allow for overlay error between the array of marks 310 and the apertures 308. That is the zone 312 may have an outer boundary defining a width between the outer boundary and the aperture 308 in the surface of the substrate 302.

In an arrangement, the pattern of marks 310 comprises a plurality of the arrays. The plurality of arrays may comprise two or more arrays having different common pitches. Additionally or alternatively, the plurality of arrays may comprise two or more arrays having the same common pitch. The plurality of arrays may comprise a plurality of one-dimensional arrays that form a two-dimensional array. As mentioned above, two or more of the arrays may comprises pluralities of marks 310 arranged along respective lines that are angled relative to each other. **FIG. 13** depicts an example arrangement in which the pattern comprises plural one-dimensional arrays 314, 316 that are angled relative to each other, for example orthogonally (although that need not be the case). The one-dimensional arrays 314, 316 may be angled relative to each other acutely or obtusely. In this example, the pattern comprises a set of one-dimensional arrays 314 aligned parallel to an X-axis (horizontally in the plane of the page) and a set of one-dimensional arrays 316 aligned parallel to a Y-axis (vertically in the plane of the page). In the arrangement shown, the one-dimensional arrays 314, 316 are positioned along planes of mirror symmetry with respect to nearest neighbor apertures 308.

In some arrangements, as exemplified in **FIG. 12** and **13**, two or more of the arrays comprise pluralities of marks arranged along respective lines that are substantially circular and coaxial with different respective apertures 308. In the examples of **FIG. 12** and **13**, one such circular array is provided around each aperture 308. In other arrangements, a plurality of circular, concentric arrays may be provided around each of one or more of the apertures 308.

The circular arrays of marks 310 surrounding apertures 308 are examples of a class of arrangement in which the plurality of marks comprise at least one group of marks (or a set of marks) positioned around at least one of the apertures 308 in a rotationally symmetric pattern, i.e., a pattern having rotational symmetry of order two or more. The rotational symmetry will typically be about an axis passing through or close to a geometrical center of the respective aperture 308. In the case of a perfectly circular aperture the geometrical center would be the center of the circle. The marks 310 in the group of marks may have a common pitch. For example, the marks 310 may be regularly spaced along at least a portion of a circular path surrounding an aperture 308 and coaxial with the aperture 308. A smallest spacing between marks in the group may be equal to or less than half of a largest dimension (e.g., a diameter of a circle or long axis of an ellipse) of the aperture 308 around which the marks are positioned.

Arranging marks 310 in a circularly symmetric pattern in this manner, particularly the marks 310 closest to the apertures 308, may reduce or avoid any unwanted net influence on electric fields from the marks 310 that might affect electrons passing through the apertures 308. Any influence arising from a first mark 310 may for example be partially or fully compensated by an influence from a second mark that is symmetrically opposite the first mark. A set of marks comprising many marks is likely to have a smaller electron-optical disturbance (or aberrational effect) on a beam through the aperture than a set of marks with a fewer marks. For a certain aperture dimension, a set of marks with a smaller pitch between adjacent marks is desirable.

In an arrangement, as exemplified in **FIG. 13**, a mark in a first of the arrays (e.g., in the circular array surrounding the upper-left aperture 308 in **FIG. 13**) and a mark in at least one second array adjacent to the first array (e.g., in the linear array 316 in between the two uppermost apertures 308 in **FIG. 13**) are separated from each other by a pitch substantially equal to a pitch of the first array and/or the pitch of at least one second array. In the example of **FIG. 13**, three marks are shown within broken line box 315. These three marks are separated from each by a common pitch. In the example shown, this common pitch is equal to a pitch of both of the circular arrays surrounding the uppermost apertures 308 in **FIG. 13**. Positioning different arrays so that they are spaced apart from each other by a pitch that is the same as a pitch within the different arrays creates additional arrays with the same pitch, thereby advantageously providing more pairs of marks that are separated from each with a common pitch. Providing more pairs of such marks may allow accuracy to be improved by averaging and/or provide more flexibility in how marks may be chosen for use in calibration.

The at least one aperture 308 may comprises a plurality of apertures 308. The plurality of apertures 308 may comprise a set of apertures defining a one-dimensional array. The apertures in the one-dimensional array may be spaced apart regularly to define an aperture pitch or beam pitch. As exemplified in **FIG. 10**, **12** and **13**, the set of apertures may be part of an aperture array arranged in a two-dimensional pattern. A cross-section of such an aperture array is shown in **FIG. 14**, which depicts a planar element such as a plate (e.g. substrate 302). The planar element has two planar surfaces 304, 306. The one-dimension array of apertures 308 each extend through the planar element between the planar surfaces 304, 306. The one-dimensional array of apertures may be aligned with a plurality of the marks 310 arranged along a line with the common pitch. The common pitch may be equal to or less than half of the aperture pitch. The common pitch (or each common pitch when there a plurality of different common pitches, for example corresponding to different respective arrays of marks 310) may be equal to or less than half of a largest dimension of one (or all) of the apertures 308. Alternatively or additionally, the common pitch (or each common pitch) may be equal to or less than half of a distance between centers of at least one pair of adjacent apertures 308.

The at least one aperture 308 may comprise a macro aperture in a multi-beam system. The macro aperture may be positioned up beam of a beam limiting aperture array, optionally directly up beam of the beam limiting aperture array. The macro aperture may operate on a beam of charged particles from a source before the beam is split into a plurality of beams of a beam grid. (The macro aperture may operate with the beam limiting aperture array to focus each of the beams, for example when setting the beam limiting aperture array to a different potential from the macro aperture array. In an arrangement the macro aperture and the beam imitating aperture array (or an aperture lens) may be controlled to operate on the beams to focus the beams at a common intermediate focal plane).

The marks 310 are formed to provide a contrast in an image that is sufficient to allow the positions of the marks 310 to be detected. In some arrangements, the marks 310 are formed with relatively low contrast in order to minimize or avoid any disruption to electric fields in the vicinity of the marks 310. For example, the marks 310 may be formed using minimal disruption to the structure, composition and/or surface finish of the electron-optical element. The resulting low contrast may not have a significant negative impact on calibration measurements performed using the marks 310 because the calibration measurements are based on detecting separations between different marks 310 rather than on details of the marks themselves. If the dimensions of the marks 310 are small relative to the separations between the marks, the calibration measurements will not be significantly affected by the low contrast.

**FIG. 15-17** schematically depict example approaches for providing the marks 310. The marks 310 may in principle take any form that allows positions of the marks to be detected in an image. The marks 310 may be defined by any one of the following in any combination: a local variation in surface topography; a local variation in surface finish (e.g., roughness); a local variation in composition.

As depicted in **FIG. 15** and **16**, in some arrangements the substrate 302 comprises a base material such as a base material 302A and a covering layer 302B on the base material 302A. In an embodiment, the covering layer 302B comprises or consists of a metallic layer. In one embodiment of this type, as exemplified in **FIG. 15**, the marks 310 are defined by recesses in the base material 302A. The recesses may be formed by shallow etching for example. The recesses in the base material 302A may cause corresponding recesses in the covering layer 302B. Marks 310 defined by shallow etched recesses in a base material that are covered by a covering layer such as a metallic layer are expected to cause minimal or no significant disruption to the local electric field when the electron-optical element is used in the electron-optical device. In another embodiment, as exemplified in **FIG. 16**, the marks may comprise localized variations in composition of the covering layer 302B. The localized variations in composition may cause corresponding local variations in density. Regions 323 corresponding to the marks 310 may have a different composition to regions 325. Varying composition while maintaining metallicity allows marks 310 to be defined with minimal or no significant disruption to the local electric field when the electron-optical element is used in the electron-optical device while still providing contrast for imaging processes, such as SEM.

**FIG. 17** exemplifies an embodiment in which the marks 310 comprise localized portions of deposited material 327. The localized portions of deposited material may be referred to as a localized coating or localized layer or portion of a layer. The localized portions of deposited material 327 may have one or more different properties relative to adjacent material. The different properties may include any difference capable of providing contrast in an image. The different properties may include a different composition and/or surface finish relative to a composition and/or surface finish of the adjacent material. The differences in composition may cause differences in density. The localized portions of deposited material 327 may also provide localized variations in topography by protruding above a level of the adjacent material (as schematically depicted in **FIG. 17**).

As is represented in **FIG. 14**, the size of the marks as such that they are not discernable in a cross-section through the substrate extending through multiple aperture 308; or at least that marks 310 have a sufficiently small dimension relative the thickness of the substrate 302 such that that they are difficult to discern at the resolution of a cross-section through a multiple of apertures 308 in the substrate 302. The layer present on the surfaces of the substrate 302 may be an applied layer or a covering layer such as metallic layer 302B. The applied layer may be applied to another layer or the material of the substrate itself.

Any of the arrangements discussed herein may be used in a method of assessing an electron-optical element for an electron-optical device. The electron-optical element and electron-optical device of the method may take any of the forms described above. The method may comprise capturing one or more images of respective portions of the substrate 302 of the electron-optical element. Such image capture may be acquired during manufacture and assembly of a stack of electron-optical elements such as during or prior to manufacture or assembly of a charged particle device, e.g. for calibration purposes. Such image capture of an electron-optical element may be acquired before securing a spacer to the electron-optical element. Various techniques may be used in principle, including optical techniques and charged particle-based techniques. High resolution is desirable. In some embodiments, the one or more images are captured using a scanning electron microscope (SEM). In some embodiments, the one or more images are captured using a field of view that is small enough to capture a full outline of only a single aperture, for example as depicted schematically in **FIG. 11**. The method may comprise detecting mark positions of at least a subset of the plurality of marks 310 in the or each image. The method may comprise determining geometrical information about one or more apertures 308 of the electron-optical element based on the one or more images and the detected mark positions. The detected mark positions may be used to calibrate a length scale along one or more directions in the or each image.

The geometrical information may comprise information about a size (e.g., cross-sectional area, or diameter information such as the diameter in the case of perfect circularity or an average, minimum or maximum diameter in cases where there are deviations from circularity) of one or more of the apertures 308. The geometrical information may include information about how size varies over a plurality of apertures (e.g., to measure an aperture size distribution); for example the geometrical information may be of the relative variation in size of apertures throughout an aperture array defined in an electron-optical element such as substrate 302.

The geometrical information may comprise information about relative positions of two or more of the apertures 308 (e.g., deviations from nominal grid positions of a regular grid). The geometrical information may include information about how deviations from nominal grid positions vary over a plurality of apertures (e.g., to measure a positional deviation distribution); for example the information may comprise the relative difference in position of the apertures of the aperture array defined in an electron-optical element such as substrate 302 relative to the nominal grid positions of the apertures in the aperture array.

The geometrical information may comprise information about a shape of one or more of the apertures 308 (e.g., ellipticity (2^{nd} order) or higher order variations from circularity such as triangularness (3^{rd} order), square-ness (4^{th} order), hexagonal-ness, etc.). The geometrical information may include information about how shape varies over a plurality of apertures (e.g., to measure an aperture shape distribution), for example the information may comprise the relative variation in shape of apertures throughout an aperture array defined in an electron-optical element such as substrate 302.

Measurement of the geometrical information of the apertures of an aperture array with reference to the measurement of the marks on the substrate surface may enable accurate determination of the perturbations applied to the different apertures of the aperture array (such as position, size and shape). Such measurement of the geometrical information of the apertures of a grid of apertures enables verification of the geometrical characteristics of the different apertures of the grid relative to the intended geometrical characteristics of the different apertures with desirably improved accuracy relative to known techniques.

Reference to a component or system of components or elements being controllable to manipulate a charged particle beam in a certain manner includes configuring a controller or control system or control unit to control the component to manipulate the charged particle beam in the manner described, as well as optionally using other controllers or devices (e.g., voltage supplies and/or current supplies) to control the component to manipulate the charged particle beam in this manner. For example, a voltage supply may be electrically connected to one or more components to apply potentials to the components, such as in a non-limited list including the control lens array 250, the objective lens array 241, and the detector array 240.

References to upper and lower, up and down, above and below, etc. should be understood as referring to directions parallel to the (typically but not always vertical) up-beam and down-beam directions of charged particle beams impinging on the sample 208. Thus, references to up beam and down beam are intended to refer to directions in respect of the beam path independently of any present gravitational field. The references to beam path are to the intended position of a corresponding beam during operation of the charged particle apertures. Such reference when made in reference to an electron-optical element, such as an electrode plate, may be generally understood to relate, for a collimated beam path, to the optical axis of the beam and thus the orthogonal to the plane of the electron-optical element. In reference to an uncollimated beam, such as a divergent beam, the beam path may be considered to be relative to the axis of the mid-point of the beam, or the mid-point of beam grid when the beam is a beam of a beam grid.

Electron-optics described herein may take the form of a series of aperture arrays or electron-optical elements arranged in arrays along a beam or a multi-beam path. Such electron-optical elements may be electrostatic. In an embodiment all the electron-optical elements, for example from a beam limiting aperture array to a last electron-optical element in a beam path before a sample, may be electrostatic and/or may be in the form of an aperture array or a plate array. In some arrangements one or more of the electron-optical elements are manufactured as a microelectromechanical system (MEMS) (i.e. using MEMS manufacturing techniques). Electron-optical elements may have magnetic elements and electrostatic elements. For example, a compound array lens may feature a macro magnetic lens encompassing the multi-beam path with an upper and lower pole plate within the magnetic lens and arranged along the multi-beam path. In the pole plates may be an array of apertures for the beam paths of the multi-beam. Electrodes may be present above, below or between the pole plates to control and optimize the electromagnetic field of the compound lens array.

An assessment apparatus, tool or system according to the disclosure may comprise apparatus which makes a qualitative assessment of a sample (e.g. pass/fail), one which makes a quantitative measurement (e.g. the size of a feature) of a sample or one which generates an image of map of a sample. Examples of assessment apparatus, tools or systems are inspection tools (e.g. for identifying defects), review tools (e.g. for classifying defects) and metrology tools, or tools capable of performing any combination of assessment functionalities associated with inspection tools, review tools, or metrology tools (e.g. metro-inspection tools).

Functionality provided by the controller or control system or control unit may be computerimplemented. Any suitable combination of elements may be used to provide the required functionality, including for example CPUs, RAM, SSDs, motherboards, network connections, firmware, software, and/or other elements known in the art that allow the required computing operations to be performed. The required computing operations may be defined by one or more computer programs. The one or more computer programs may be provided in the form of media, optionally non-transitory media, storing computer readable instructions. When the computer readable instructions are read by the computer, the computer performs the required method steps. The computer may consist of a self-contained unit or a distributed computing system having plural different computers connected to each other via a network.

While the present invention has been described in connection with various embodiments, other embodiments of the invention will be apparent to those skilled in the art from consideration of the specification and practice of the invention disclosed herein. It is intended that the specification and examples be considered as exemplary only, with a true scope and spirit of the invention being indicated by the following claims and clauses.

There is provided the following clauses:
Clause 1. An electron-optical element for an electron-optical device, the electron-optical element comprising: a substrate having two planar surfaces and defining at least one aperture extending through the substrate between the two planar surfaces, wherein: at least one of the planar surfaces comprises a plurality of marks formed on or in the planar surface, a distance between centers of at least one pair of adjacent marks being: equal to or less than half of a largest dimension of one of the at least one aperture; and/or equal to or less than half of a distance between centers of at least one pair of adjacent apertures, in a case where the at least one aperture comprises a plurality of apertures.
Clause 2. The element of clause 1, wherein the plurality of marks are arranged in a pattern.
Clause 3. The element of clause 2, wherein the pattern comprises an array of the marks having a common pitch.
Clause 4. The element of clause 3, wherein the array of marks comprises a plurality of marks arranged along a line with the common pitch, desirably three or more marks.
Clause 5. The element of clause 4, wherein the line is straight.
Clause 6. The element of clause 4, wherein the line is curved.
Clause 7. The element of clause 6, wherein the line surrounds one of the apertures.
Clause 8. The element of clause 7, wherein the line is substantially circular and coaxial with the aperture.
Clause 9. The element of any of clauses 3 to 8, wherein the array is a two-dimensional array, optionally having different common pitches parallel to different respective axes of the two-dimensional array.
Clause 10. The element of clause 9, wherein the two-dimensional array comprises a grid, optionally a rectangular grid, a hexagonal grid, or a rhomboidal grid.
Clause 11. The element of any of clauses 3 to 10, wherein the pattern comprises a plurality of the arrays.
Clause 12. The element of clause 11, wherein two or more of the arrays comprise pluralities of marks arranged along respective lines that are angled relative to each other.
Clause 13. The element of clause 12, wherein two or more of the arrays comprise pluralities of marks arranged along respective lines that are substantially circular and coaxial with different respective apertures.
Clause 14. The element of any of clauses 11 to 13, wherein the plurality of arrays comprises: two or more arrays having different common pitches; and/or two or more arrays having the same common pitch.
Clause 15. The element of any of clauses 11 to 14, wherein a mark in a first of the arrays and a mark in at least one second array adjacent to the first array are separated from each other by a pitch substantially equal to a pitch of the first array and/or a pitch of the at least one second array.
Clause 16. The element of any of clauses 3 to 15, wherein: the at least one aperture comprises a plurality of apertures; and the plurality of apertures comprises a set of apertures defining a one-dimensional array, desirably having an aperture pitch, desirably the set of apertures being part of an aperture array arranged in a two-dimensional pattern.
Clause 17. The element of clause 16, wherein the one-dimensional array of apertures is aligned with a plurality of the marks arranged along a line with the common pitch.
Clause 18. The element of clause 17, wherein the common pitch is equal to or less than half of the aperture pitch.
Clause 19. The element of any of clauses 3 to 18, wherein the common pitch, or each common pitch, is: equal to or less than half of a largest dimension of one of the at least one aperture; and/or equal to or less than half of a distance between centers of at least one pair of adjacent apertures, in a case where the at least one aperture comprises a plurality of apertures.
Clause 20. The element of any preceding clause, wherein the plurality of marks comprises a group of marks positioned around at least one of the apertures in a rotationally symmetric pattern, the rotationally symmetry pattern having rotational symmetry of order two or more.
Clause 21. The element of clause 20, wherein the group of marks comprises an array of marks having a common pitch.
Clause 22. The element of clause 20 or 21, wherein a smallest spacing between marks in the group is equal to or less than half of a largest dimension of the aperture around which the marks are positioned.
Clause 23. The element of any preceding clause, wherein the substrate comprises a base material and a covering layer on the base material, the covering layer desirably comprising a metallic layer.
Clause 24. The element of any proceeding clause, wherein the marks are defined by local variations in a topography, optionally local recesses in the substrate or in a base material of the substrate.
Clause 25. The element of clause 23 or 24, wherein the marks are defined by local variations in composition and/or a surface finish of the substrate.
Clause 26. The element of any preceding clause, wherein the marks comprise localized portions of deposited material desirably having one or more different properties relative to adjacent material, such as a different composition and/or surface finish relative to a composition and/or surface finish of the adjacent material.
Clause 27. An electron-optical device comprising a stack of electron-optical elements configured to allow manipulation of at least one charged particle beam propagating along a beam path through the stack by application of different potentials to the electron-optical elements, wherein the stack comprises at least one of the electron-optical elements of any preceding clause.
Clause 28. The device of clause 27, further comprising a detector configured to detect signal charged particles from the sample.
Clause 29. An assessment apparatus for assessing a sample using charged particles, the apparatus comprising: a sample support configured to support a sample; and the device of clause 27 or 28 configured to project at least one charged particle beam towards the sample.
Clause 30. A method of assessing an electron-optical element for an electron-optical device, wherein the electron-optical element comprises: a substrate having two planar surfaces and defining at least one aperture extending through the substrate between the two planar surfaces, wherein: at least one of the planar surfaces comprises a plurality of marks formed on or in the planar surface, a distance between centers of at least one pair of adjacent marks being: equal to or less than half of a largest dimension of one of the at least one aperture; and/or equal to or less than half of a distance between centers of at least one pair of adjacent apertures, in a case where the at least one aperture comprises a plurality of apertures, and wherein the method comprises: capturing one or more images of respective portions of the substrate; detecting mark positions of at least a subset of the plurality of marks in the or each image; and determining geometrical information about the at least one aperture based on the one or more images and the detected mark positions.
Clause 31. The method of clause 30, wherein the geometrical information comprises one or more of the following: information about a size of one or more of the at least one aperture; information about relative positions of two or more of the apertures; and information about a shape of one or more of the at least one aperture.
Clause 32. The method of clause 30 or 31, wherein the determining geometrical information comprises using the detected mark positions to calibrate a length scale along one or more directions in the or each image.
Clause 33. The method of any of clauses 30 to 32, wherein the one or more images are captured using a scanning electron microscope.

## Claims

1. An electron-optical element for an electron-optical device, the electron-optical element comprising:
a substrate having two planar surfaces and defining at least one aperture extending through the substrate between the two planar surfaces, wherein:
at least one of the planar surfaces comprises a plurality of marks formed on or in the planar surface, a distance between centers of at least one pair of adjacent marks being:
equal to or less than half of a largest dimension of one of the at least one aperture; and/or
equal to or less than half of a distance between centers of at least one pair of adjacent apertures, in a case where the at least one aperture comprises a plurality of apertures.

2. The element of claim 1, wherein the plurality of marks are arranged in a pattern.

3. The element of claim 2, wherein the pattern comprises an array of the marks having a common pitch.

4. The element of claim 3, wherein the array of marks comprises a plurality of marks arranged along a line with the common pitch, desirably three or more marks.

5. The element of claim 4, wherein the line is straight.

6. The element of claim 4, wherein the line is curved.

7. The element of claim 6, wherein the line surrounds one of the apertures.

8. The element of claim 7, wherein the line is substantially circular and coaxial with the aperture.

9. The element of any of claims 3 to 8, wherein the array is a two-dimensional array, optionally having different common pitches parallel to different respective axes of the two-dimensional array.

10. The element of any of claims 3 to 9, wherein the pattern comprises a plurality of the arrays, desirably wherein two or more of the arrays comprise pluralities of marks arranged along respective lines that are angled relative to each other.

11. The element of claim 10, wherein the plurality of arrays comprises:
two or more arrays having different common pitches; and/or
two or more arrays having the same common pitch.

12. The element of claim 10 or 11, wherein a mark in a first of the arrays and a mark in at least one second array adjacent to the first array are separated from each other by a pitch substantially equal to a pitch of the first array and/or a pitch of the at least one second array.

13. The element of any of claims 3 to 12, wherein:
the at least one aperture comprises a plurality of apertures; and
the plurality of apertures comprises a set of apertures defining a one-dimensional array, desirably having an aperture pitch, desirably the set of apertures being part of an aperture array arranged in a two-dimensional pattern.

14. The element of claim 13, wherein the one-dimensional array of apertures is aligned with a plurality of the marks arranged along a line with the common pitch.

15. The element of any of claims 3 to 14, wherein the common pitch, or each common pitch, is:
equal to or less than half of a largest dimension of one of the at least one aperture; and/or
equal to or less than half of a distance between centers of at least one pair of adjacent apertures, in a case where the at least one aperture comprises a plurality of apertures.
